# EUROPÄISCHE PATENTANMELDUNG

(11) **EP 1 379 113 A2**
(43) Veröffentlichungstag der Anmeldung: **07.01.2004**
(21) Anmeldenummer: 03014773.0
(22) Anmeldetag: 27.06.2003
(51) Int. Cl.: H05K 1/02

(54) **Leiterplatte mit einem elektrischen leitfähigen Verstärkungselement**

(30) Priorität: 27.06.2002 DE 10228756
(71) Anmelder: EPCOS AG, 81669 München (DE)
(72) Erfinder: Riedel, Gerd, 89522 Heidenheim (DE); Feth, Josef, 89522 Heidenheim (DE); Flämig, Gerd, 89518 Heidenheim (DE)
(74) Vertreter: Epping Hermann & Fischer

(57) **Zusammenfassung**

Die Erfindung betrifft eine Leiterplatte mit einer Leiterbahn (4) und mit einem elektrisch leitfähigen Verstärkungselement (2), das mittels eines Befestigungselements (3) an der Leiterplatte (1) befestigt ist und das wenigstens zwei Punkte der Leiterbahn (4) elektrisch leitend miteinander verbindet. Die erfindungsgemäße Leiterplatte hat den Vorteil, daß sie partiell sehr hohe Ströme aushalten kann. Darüber hinaus gibt die Erfindung eine Leiterplattenanordnung sowie die Verwendung der Leiterplatte an.

## Beschreibung

Die Erfindung betrifft eine Leiterplatte mit wenigstens einer Leiterbahn. Darüber hinaus betrifft die Erfindung eine Leiterplattenanordnung sowie die Verwendung der Leiterplatte.

Es sind Leiterplatten der eingangs genannten Art bekannt, bei denen die Leiterplatten gedruckte Schaltungen mit einer Dicke von etwa 35 - 70 µm enthalten. Solche Leiterplatten werden verwendet in elektrotechnischen und elektronischen Geräten zur Montage von elektrischen Bauelementen und zum Verdrahten der Bauelemente untereinander mittels der Leiterbahnen der gedruckten Schaltungen. Es werden dabei zunehmend mehr elektrische Bauteile einbezogen, die einen hohen Betriebsstrom aufweisen. Ein hoher Betriebsstrom liegt beispielsweise zwischen 1 A und 80 A. Solche hohen Ströme können aufgrund des geringen Leitungsquerschnitt in den Leiterbahnen der herkömmlichen Leiterplatten nicht mehr transportiert werden. Aufgrund der großen Hitzeentwicklung bei geringem Leitungsquerschnitt besteht die Gefahr, daß die Leiterbahnen durch die Hitze zerstört werden.

Um die Verwendung von Bauteilen mit hohem Betriebsstrom zu ermöglichen, sind Leiterplatten hergestellt worden, bei denen die Strombelastbarkeit durch Verbreiterung der Leiterbahnen erreicht wurde. Diese Leiterplatten haben den Nachteil, daß sie einen erhöhten Flächenbedarf aufweisen, wodurch die oftmals gewünschte Integrationsdichte von elektrischen Bauelementen nicht mehr erreicht werden kann.

Darüber hinaus sind Leiterplatten hergestellt worden, bei denen die Schichtdicken der Leiterbahnen durch elektrochemisches Auftragen von einer dickeren Metallschicht erhöht worden sind. Dadurch kann die Strombelastbarkeit der Leiterbahnen erhöht werden, was an sich die Verwendung von Bauelementen mit hohem Betriebsstrom ermöglicht. Diese Leiterplatten haben allerdings den Nachteil, daß das elektrochemische Verfahren zum Verdicken der Leiterbahnen einen aufwendigen Prozeß darstellt, der entsprechend die Leiterplatten verteuert.

Desweiteren sind Leiterplatten bekannt, bei denen die Verdrahtung an kritischen Stellen, an denen hohe Ströme durch Leiterbahnen fließen würden, durch die herkömmliche Verdrahtungstechnik ersetzt worden ist. Diese Leiterplatten haben den Nachteil, daß auf die bekannten Vorteile der gedruckten Schaltung verzichtet werden muß.

Ziel der vorliegenden Erfindung ist es daher, eine Leiterplatte zum Tragen von elektrischen Bauelementen und zum Verschalten dieser Bauelemente anzugeben, bei der auf einfache und kostengünstige Art und Weise die Leiterbahnen mit hohen elektrischen Strömen belastet werden können.

Dieses Ziel wird erfindungsgemäß durch eine Leiterplatte nach Patentanspruch 1 erreicht. Vorteilhafte Ausgestaltungen der Erfindung, eine Leiterplattenanordnung sowie die Verwendung der Leiterplatte sind den folgenden Patentansprüchen zu entnehmen.

Die Erfindung gibt eine Leiterplatte an. Darüber hinaus weist die Leiterplatte ein elektrisch leitfähiges Verstärkungselement auf, das mittels Befestigungselementen an der Leiterplatte befestigt ist. Die Befestigung erfolgt dabei so, daß das Verstärkungselement wenigstens zwei Punkte einer Leiterbahn der Leiterplatte elektrisch leitend miteinander verbindet.

Die erfindungsgemäße Leiterplatte hat den Vorteil, daß durch die elektrisch leitfähige Verstärkung die Stromtragfähigkeit zwischen den Punkten der Leiterbahn verbessert werden kann. Dadurch sinkt der elektrische Widerstand zwischen den Punkten und mithin wird die thermische Belastung der Leiterplatte beziehungsweise der Leiterbahn verringert. Die Leiterbahnverstärkung kann dabei aus jedem beliebigen leitfähigen Material hergestellt sein, wobei es jedoch vorteilhaft ist, wenn die Verstärkung lötfähig ist. Insbesondere können mit Hilfe der Erfindung standardmäßig verfügbare Leiterplatten in ihrer Stromtragfähigkeit verbessert werden. Bei der Leiterplatte kann es sich dabei insbesondere um eine elektrisch isolierende Trägerplatte handeln, die mit Leiterbahnen versehen ist, welche integrale Bestandteile der Trägerplatte sind. Als Leiterbahnen kommen insbesondere Kupferkaschierungen auf Trägermaterial in Betracht.

Eine vorteilhafte Befestigung des Verstärkungselements kann erreicht werden, indem als Befestigungselement ein Rohrniet durch ein Loch gesteckt ist, das durch die Leiterplatte und das Verstärkungselement ragt. Dabei wird davon ausgegangen, daß das Loch des Verstärkungselements und das Loch der Leiterplatte konzentrisch übereinander liegen.

Die Verbindung zwischen dem Verstärkungselement und der Leiterplatte kann durch eine formschlüssige Verbindung mittels des Befestigungselementes erfolgen.

Eine solche formschlüssige Verbindung kann beispielsweise unterstützt werden, indem der Rohrniet auf beiden Seiten der Leiterplatte jeweils einen nach außen gebogenen Abschnitt aufweist. Dieser nach außen gebogene Abschnitt verhindert, daß der Rohrniet aus dem Loch herausfallen kann. Dabei befindet sich der nach außen gebogene Abschnitt zum einen auf der dem Verstärkungselement entgegengesetzten Seite der Leiterplatte und zum anderen auf der der Leiterplatte entgegengesetzten Seite des Verstärkungselements.

Der Rohrniet kann beispielsweise auf einer Seite einen Flansch aufweisen und auf der anderen Seite durch einen erweiterten Abschnitt in dem Loch beziehungsweise auf der Leiterplatte oder auf dem Verstärkungselement fixiert sein.

Das elektrisch leitfähige Verstärkungselement kann beispielsweise ein Kupferblech sein.

Die Befestigung des Verstärkungselements mittels eines Hohlnietes hat desweiteren den Vorteil, daß die Stelle, an der sich der Hohlniet befindet, gleichzeitig ein Leiter mit der Leiterplatte verbunden werden kann. Es kann der Leiter in den Hohlniet eingeführt und mit diesem verlötet sein. Darüber hinaus kann durch geeignete Wahl des Leiterquerschnitts im Verhältnis zum inneren Querschnitt des Hohlniets dafür gesorgt werden, daß der von der Oberseite in den Hohlniet eingeschobene elektrische Leiter und das auf der Unterseite der Leiterplatte angeordnete Verstärkungselement miteinander verlötet werden. Dabei wird das Lot über bekannte Lötverfahren aufgebracht, und durch geeignete Dimensionierung der Verhältnisse zwischen Leiteraußendurchmesser und Befestigungselement-Innendurchmesser eine Kapillarwirkung erzielt werden, die eine ausreichend gute Verbindung ergibt, wobei zusätzlich eine Lotkuppe an der Leiterplattenunterseite entstehen kann.

Diese Lotkuppe stellt dann die Lötverbindung zwischen dem elektrischen Leiter und dem Verstärkungselement dar. Durch eine solche Lötverbindung kann dafür Sorge getragen werden, daß der durch den elektrischen Leiter in die Leiterplatte eingekoppelte hohe Strom direkt auf das elektrisch leitende Verstärkungselement übertragen wird.

Darüber hinaus gibt die Erfindung eine Leiterplattenanordnung an, die eine erfindungsgemäße Leiterplatte enthält. Die Leiterplatte ist dabei so gestaltet, daß die Befestigung des Verstärkungselements an der Leiterplatte mittels eines Rohrnietes, wie bereits weiter oben beschrieben, erfolgt. Durch den Rohrniet ist das Anschlußelement eines elektrischen Bauelements geschoben. Das Anschlußelement ist an dem Rohrniet befestigt. Die Befestigung des Anschlußelementes des elektrischen Bauelements an dem Rohrniet kann beispielsweise durch Löten erfolgen.

Die erfindungsgemäße Leiterplattenanordnung hat den Vorteil, daß die Leiterplatte an der Stelle, wo der Rohrniet in der Leiterplatte angeordnet ist, eine erhöhte Stabilität zur Befestigung von Bauelementen aufweist. Dies gilt um so mehr, wenn der Rohrniet an seinen Enden nach außen gebogene Abschnitte aufweist, die in gewisser Weise eine Umfassung der Leiterplatte beziehungsweise des Verstärkungselements darstellen. Demnach eignen sich die Stellen, an denen die Rohrniete die Verbindung zwischen dem Verstärkungselement und der Leiterplatte herstellen, auch besonders gut zur Befestigung von elektrischen Bauelementen. Da die mechanische Stabilität der Leiterplatte an diesen Stellen erhöht ist, eignet sich die erfindungsgemäße Leiterplattenanordnung auch insbesondere zur Anordnung von elektrischen Bauelemente auf der Leiterplatte, die eine hohe Masse aufweisen. Beispielsweise können vorteilhaft Bauelemente mit einer Masse von größer als 10 - 30 g auf der Leiterplatte montiert werden, ohne daß die Gefahr besteht, daß die Leiterplatte an der Lötstelle zwischen dem schweren Bauelement und der Leiterplatte beschädigt wird. Eine solche Beschädigung könnte insbesondere aufgrund von mechanischen Vibrationen in Betracht kommen.

Insbesondere ist es vorteilhaft, für die erfindungsgemäße Leiterplattenanordnung elektrische Bauelemente zu verwenden, die eine Masse > 100 g aufweisen.

Entsprechend dem Vorteil der erfindungsgemäßen Leiterplatte, hohe Ströme entlang bestimmter Leiterbahnen fließen lassen zu können, gibt die Erfindung die Verwendung einer erfindungsgemäßen Leiterplatte an, wobei eine Leiterplatte verwendet wird, die für Ströme bis zu einem maximalen Strom, z.B. bis zu 18 A geeignet ist. Eine solche Leiterplatte verfügt typischerweise über Leiterbahnen mit einer Breite von etwa 0,25 mm und einer Dicke von zirka 70 µm und wird verwendet bei einer Temperaturdifferenz zwischen Leiterplatte und Umgebung von zirka 20 K. Diese standardmäßig erhältlichen Leiterplatten werden nun verwendet bei Anwendungen, bei denen entlang von Leiterbahnen, deren Stromtragfähigkeit durch ein erfindungsgemäßes Verstärkungselement erhöht worden ist, Ströme fließen, die wenigstens zweimal so groß sind wie der maximale Strom, die also beispielsweise zwischen 50 und 100 A betragen.

Die erfindungsgemäße Leiterplatte hat darüber hinaus den Vorteil, daß die Verstärkung von Leiterbahnen auf die Hochstrom tragenden Pfade beschränkt werden kann, während die übrigen Leiterbahnen in der Standardausführung verbleiben können. Dadurch wird eine selektive Verstärkung ermöglicht, die nur dort durchgeführt wird, wo sie auch wirklich notwendig ist, womit Material, Gewicht und Kosten eingespart werden können.

Aufgrund der Möglichkeit, bei der erfindungsgemäßen Leiterplattenanordnung eine sichere Lötverbindung zwischen einem Bauelement und dem Befestigungselement für das Verstärkungselement zu erzielen, kann in vielen Fällen auf eine zusätzliche Befestigung oder Fixierung von schweren Bauelementen mit großen Leitungsquerschnitten verzichtet werden.

Insbesondere wird durch die Erfindung auch ermöglicht, Starkund Schwachstromkomponenten auf einer einzigen Leiterplatte miteinander zu vereinen.

Im folgenden wird die Erfindung anhand von Ausführungsbeispielen und den dazugehörigen Figuren näher erläutert:
- Figur 1: zeigt beispielhaft eine erfindungsgemäße Leiterplatte im schematischen Querschnitt.
- Figur 2: zeigt beispielhaft eine erfindungsgemäße Leiterplattenanordnung im schematischen Querschnitt.

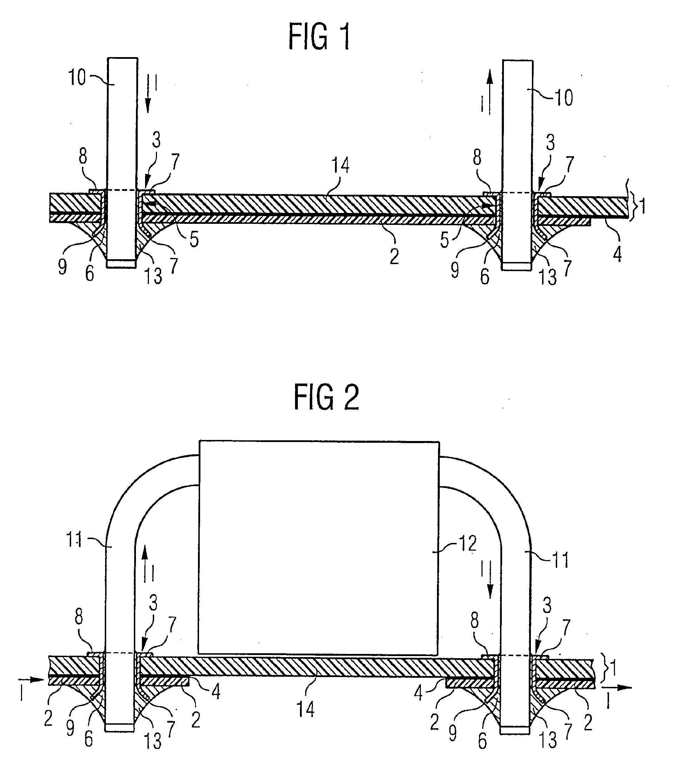

Figur 1 zeigt eine Leiterplatte 1, die aus einer isolierenden Trägerplatte 14 und einer auf der Unterseite der Trägerplatte 13 angeordneten Leiterbahn 4 besteht. Die Leiterbahn 4 ist dabei integraler Bestandteil der Leiterplatte 1. Sie kann beispielsweise durch Siebdrucken, Ätztechnik oder auch durch andere in der Leiterplattentechnik üblichen Herstellungsverfahren auf die Trägerplatte 13 aufgebracht sein. Als Material für die Trägerplatte 13 kommt beispielsweise Phenolharz oder auch Epoxidharz in Betracht. Diese Materialien werden üblicherweise bei FR2 oder FR4-Leiterplatten verwendet. Die Leiterbahn 4 kann beispielsweise aus Kupfer bestehen. Üblicherweise verwendete Standard-Leiterplatten weisen Leiterbahnen auf, die eine Dicke von maximal 17,5 bis 105 µm aufweisen. Auf der Unterseite der Leiterplatte 1 ist ein Verstärkungselement 2 angeordnet, das beispielsweise ein Kupferblech mit einer Dicke von 0,5 - 2 mm sein kann.

Das Verstärkungselement 2 kann ein elektrisch leitendes Blech, zum Beispiel ein Metallblech sein, das flächig auf einer Seite der Leiterplatte 1 anliegt. Die Befestigung des Verstärkungselements 2, das elektrisch leitfähig ist und das zwei Punkte der Leiterbahn 4 miteinander kontaktiert, kann mittels Befestigungselementen 3 erfolgen. In der Ausführungsform gemäß Figur 1 sind die Befestigungselemente 3 Rohrnieten 5, die auf der Oberseite der Leiterplatte 1 jeweils einen nach außen gebogenen Abschnitt 7 aufweisen. Die Rohrnieten 5 ragen durch ein Loch 6, das in der Leiterplatte 1 (also in der Trägerplatte 14 und in der Leiterbahn 4) und in dem Verstärkungselement 2 angeordnet ist. Der Rohrniet 5 ragt durch das Loch. Der Rohrniet 5 ist in das Loch 6 eingeschoben. Auf der Rückseite der Leiterplatte 1, unterhalb des Verstärkungselements 2 weist der Rohrniet 5 ebenfalls einen nach außen gebogenen Abschnitt 7 auf. Gemäß der Ausführungsform in Figur 1 ist der obere nach außen ragende Abschnitt 7 des Rohrniets 5 als Flansch 8 ausgeführt. Dieser Flansch 8 kann schon vor dem Einführen des Rohrniets 5 in das Loch 6 dort angeordnet sein. Es bietet sich demnach die Verwendung eines entsprechend geformten Spezialteiles an. Der Rohrniet kann allerdings auch aus einfachen Rohrabschnitten gefertigt sein. Als Material für den Rohrniet kommt verzinntes Kupfer in Betracht. Der Rohrniet kann beispielsweise einen Innendurchmesser von 3,2 mm und einen Außendurchmesser von 4,0 mm aufweisen. Ein solcher Rohrniet hat eine Wandstärke von 0,4 mm.

Der auf der Unterseite der Leiterplatte 1 befindliche nach außen gebogene Abschnitt 7 des Rohrnietes 5 kann als erweiterter Abschnitt 9 ausgeführt sein. Ein solcher erweiterter Abschnitt 9 kann beispielsweise hergestellt werden durch ein Nietwerkzeug. Dadurch wird der Rohrniet 5 gewissermaßen an der Unterseite der Leiterplatte 1 ein Stück umgebördelt, wodurch ein formschlüssige Befestigung zwischen dem Verstärkungselement 2 und der Leiterplatte 1 hergestellt werden kann. Der mit den beiden Pfeilen gekennzeichnete elektrische Strom I kann in die erfindungsgemäße Leiterplatte durch elektrische Leiter 10 eingekoppelt werden. Diese elektrischen Leiter 10 können beispielsweise Drähte sein. Sie werden in der in Figur 1 gezeigten vorteilhaften Ausführungsform der Erfindung durch die Rohrnieten 5 geschoben und mit den Rohrnieten 5 beziehungsweise mit dem Verstärkungselement 2 verlötet. Zum Löten wird Lot 13 verwendet. Die Trägerplatte hat das Bezugszeichen 14. Wie bei den üblichen Lötverfahren wird dabei im Schwallbad oder z.B. auch mit Handlötung gearbeitet, wodurch das Lot 13 von der Unterseite der Leiterplatte 1 an die Lötstelle herangeführt wird. Durch geeignete Wahl des Durchmesser der elektrischen Leiter 10 im Verhältnis zum Innendurchmesser der Rohrnieten 5 kann eine Kapillarwirkung erreicht werden, wodurch Lot 13 in den Zwischenraum zwischen dem elektrischen Leiter 10 und der Innenseite des Rohrnietes 5 gelangt und so für eine Verlötung zwischen elektrischem Leiter 10 und Rohrniet 5 sorgt. Der an dem linken elektrischen Leiter 10 eingekoppelte Strom I kann über die Leiterbahn 4 sowie über das Verstärkungselement 2 auf die rechte Seite der Leiterplatte fließen, wo er mittels dem rechten elektrischen Leiter 10 wieder aus der Leiterplatte 1 ausgekoppelt wird. Bei der Leiterplatte 1 kann es sich dabei um eine übliche Leiterplatte handeln, deren Leiterbahnen eine Dicke von zirka 70 µm aufweist.

Figur 2 zeigt eine erfindungsgemäße Leiterplattenanordnung, wobei eine Leiterplatte gemäß der Erfindung wie entsprechend der in Figur 1 gezeigten Darstellung enthalten ist. Im Unterschied zu Figur 1 sind anstelle der elektrischen Leiter 10 nun die Anschlußelemente 11 eines elektrischen Bauelements 12 mit der Leiterplatte 1 verlötet. Die Stromzuführung zum Bauelement 12 erfolgt über die auf der linken Seite der Leiterplatte 1 beziehungsweise auf der rechten Seite der Leiterplatte 1 angeordnete durch ein Verstärkungselement 2 jeweils verstärkte Leiterbahn 4. Als Bauelement 12 können insbesondere auch massive Bauelemente mit einer großen Matte verwendet werden. Beispielsweise kann eine Drossel einem Gewicht von mehreren 100 g, wie sie für viele Bereiche der Elektronik, insbesondere EMV-Anwendungen verwendet wird, auf der erfindungsgemäßen Leiterplatte aufgebaut werden. Das Anlöten der Anschlußelemente 11 des Bauelements 12 auf der Leiterplatte 1 erfolgt in einer zu der in Figur 1 gezeigten analogen Weise.

Die gezeigte Erfindung beschränkt sich nicht auf ebene Leiterplatten, sondern sie kann durchaus auch auf gekrümmte oder sonst wie von der ebenen Form abweichende Leiterplatten angewendet werden. Darüber hinaus beschränkt sich die Erfindung nicht auf die Befestigung des Verstärkungselements mittels eines Rohrnietes. Vielmehr kann als Befestigungselement z.B. auch eine Schraube oder auch Klebstoff dienen.

### Bezugszeichenliste

- 1: Leiterplatte
- 2: Verstärkungselement
- 3: Befestigungselement
- 4: Leiterbahn
- 5: Rohrniet
- 6: Loch
- 7: Abschnitt
- 8: Flansch
- 9: Abschnitt
- 10: elektrischer Leiter
- 11: Anschlußelement
- 12: Bauelement
- 13: Lot
- 14: Trägerplatte
- I: Strom

## Patentansprüche

1. Leiterplatte
- mit einer Leiterbahn (4),
- mit einer Trägerplatte (14), wobei die Leiterbahn (4) integraler Bestandteil der Trägerplatte (14) ist, und
- mit einem elektrisch leitfähigen Verstärkungselement (2), das mittels eines Befestigungselements (3) an der Leiterplatte (1) befestigt ist und das wenigstens zwei Punkte der Leiterbahn (4) elektrisch leitend miteinander verbindet,
- wobei das Befestigungselement (3) durch einen Rohrniet (5) gebildet ist, der in ein durch die Trägerplatte (14), die Leiterbahn (4) und das Verstärkungselement (2) ragendes Loch (6) gesteckt ist,
- wobei der Rohrniet (5) durch einen auf beiden Seiten der Leiterplatte (1) nach außen gebogenen Abschnitt (7) die formschlüssige Verbindung der Trägerplatte (14), der Leiterbahn (4) und des Verstärkungselements (2) unterstützt.

2. Leiterplatte nach Anspruch 1,
bei dem der Rohrniet (5) auf einer Seite der Leiterplatte (1) einen Flansch (8) und auf der anderen Seite einen erweiterten Abschnitt (9) aufweist, durch den der Rohrniet (5) in dem Loch (6) fixiert ist.

3. Leiterplatte nach Anspruch 1 oder 2,
bei dem das Verstärkungselement (2) ein metallisches Blech ist.

4. Leiterplatte nach einem der Ansprüche 1 bis 3,
bei dem in dem Rohrniet (5) ein elektrischer Leiter (10) angeordnet ist, der in dem Hohlniet (5) befestigt ist.

5. Leiterplatte nach Anspruch 4,
bei dem der Leiter (10) mit dem Verstärkungselement (2) verlötet ist.

6. Leiterplattenanordnung mit einer Leiterplatte nach einem der Ansprüche 1 bis 5,
bei der ein Anschlußelement (11) eines elektrischen Bauelements (12) in dem Rohrniet (5) befestigt ist.

7. Leiterplattenanordnung nach Anspruch 6,
bei der das elektrische Bauelement (12) eine Masse von wenigstens 100 g aufweist.

8. Leiterplattenanordnung nach Anspruch 7,
bei der das elektrische Bauelement (12) eine Masse von wenigstens 500 g aufweist.

9. Verwendung einer Leiterplatte nach einem der Ansprüche 1 bis 7 mit für Ströme bis zu einem maximalen Strom geeigneten Leiterbahnen (4) für Anwendungen, bei denen in den mit einem Verstärkungselement (2) versehenen Leiterbahnen (4) Ströme fließen, die wenigstens zweimal so groß sind wie der maximale Strom.
